# EUROPEAN PATENT APPLICATION

(11) **EP 4 178 322 A1**
(43) Date of publication of application: **10.05.2023**
(21) Application number: 21858070.2
(22) Date of filing: 09.07.2021
(51) Int. Cl.: H05H 1/24, G03F 7/20, H05G 2/00

(54) **EXTREME ULTRAVIOLET LIGHT SOURCE DEVICE**

(30) Priority: 21.08.2020 JP 2020139864
(71) Applicant: Ushio Denki Kabushiki Kaisha, Tokyo 100-8150 (JP)
(72) Inventor: ASHIZAWA, Noritaka, Tokyo 100-8150 (JP); YABUTA, Hironobu, Tokyo 100-8150 (JP)
(74) Representative: Tomerius, Isabel
(86) International application number: PCT/JP2021/025928
(87) International publication number: WO 2022/038921

(57) **Abstract**

An extreme ultraviolet light source apparatus includes a light source part configured to generate a plasma that emits extreme ultraviolet light; a vacuum housing located between the light source part and a utilizing apparatus in which the extreme ultraviolet light is utilized; a debris trap located inside the vacuum housing to deflect traveling directions of debris particles emitted from the plasma toward the utilizing apparatus from a ray direction of the extreme ultraviolet light; a heat shield panel structure located inside the vacuum housing and located between the plasma and the debris trap; and a cooling mechanism for cooling the heat shield panel structure. The heat shield panel structure has a first heat shield panel and a second heat shield panel overlapping the first heat shield panel, the first heat shield panel and the second heat shield panel being disposed at an interval. The second heat shield panel is disposed between the first heat shield panel and the plasma. The first heat shield panel is cooled by the cooling mechanism.

## Description

### TECHNICAL FIELD

The present invention relates to extreme ultraviolet light source apparatuses.

### BACKGROUND ART

Recently, due to increasing miniaturization and integration of semiconductor integrated circuits, shortening of a wavelength of an exposure light source has been promoted. As a next-generation light source for exposing semiconductors, an extreme ultraviolet light source apparatus (hereinafter also referred to as an "EUV light source apparatus") that emits extreme ultraviolet light (hereinafter also referred to as "EUV (extreme ultraviolet) light") having a wavelength of 13.5 nm has been developed.

There are several known methods for generating EUV light (EUV radiation) in an EUV light source apparatus. One method is to generate a high-temperature plasma by heating and exciting an extreme ultraviolet light radiation subject (hereinafter, also referred to as "EUV radiation subject"), and to generate EUV light emitted from the high-temperature plasma.

EUV light source apparatuses that employ such a method are classified into an LPP (Laser Produced Plasma) method and a DPP (Discharge Produced Plasma) method, depending on the generation scheme.

An EUV light source apparatus of the DPP type applies a high voltage to a gap between electrodes in which a discharge gas containing EUV radiation subject (plasma raw material in a gas phase) is supplied, to generate a high-density and high-temperature plasma by discharge, and utilizes extreme ultraviolet light radiated therefrom. As a specific DPP method as disclosed, for example, in Patent Document 1, a method is proposed in which a liquid high-temperature plasma raw material (for example, Sn (tin)) is supplied to surfaces of electrodes that generate a discharge, an energy beam such as a laser beam is directed to the raw material to vaporize the raw material, and a high-temperature plasma is generated by the discharge. Such an approach may be referred to as LDP (Laser Assisted Discharge Plasma).

The EUV light source apparatus is used as a light source apparatus in a lithography apparatus for manufacturing semiconductor devices. Alternatively, the EUV light source apparatus is used as a light source apparatus in an apparatus for inspecting masks used for lithography. That is to say, the EUV light source apparatus is used as a light source apparatus in another optical apparatus (utilizing apparatus), which uses EUV light.

Since EUV light is easily attenuated in the atmosphere, the area from the plasma to the utilizing apparatus is placed in a reduced-pressure atmosphere, that is, in a vacuum environment.

On the other hand, debris is emitted at high speed from the plasma generated by the LDP system. The debris includes tin particles, which are the raw material for the high-temperature plasma, and material particles of the discharge electrodes, which are results of slight chipping of the discharge electrodes due to the energy beam irradiation. Since the debris particles may damage or contaminate reflective films of optical elements in the utilizing apparatus and may degrade its performance when they reach the utilizing apparatus, a debris trap has been proposed to deflect the traveling directions of emitted debris particles so that the debris particles do not ingress into the utilizing apparatus (Patent Document 1).

A debris trap uses multiple foils that divide a space in which the debris trap is disposed, and reduces the conductance in the divided sections to increase the pressure. Since the probability of collision of the debris particles with an ambient gas increases in the sections, in which the pressure is increased, the speed of the debris particles is reduced and the traveling directions of the debris particles are deflected from the direction of the EUV light beam. There are two types of debris traps: a stationary foil trap in which the positions of the multiple foils are stationary and a rotating foil trap in which debris particles having relatively large mass and having a low speed are trapped by rotating the foils in a direction perpendicular to the original traveling direction of the debris particles. A single apparatus may be provided with both or one of the two types of traps.

A heat shield panel is placed between the debris trap and the plasma. One purpose of placing the heat shield panel is to prevent the debris trap from being overheated and damaged by heat radiation from the plasma. Another purpose of placing the heat shield panel is to reduce the load on the debris trap by minimizing the amount of debris particles traveling toward the debris trap. The heat shield panel has an aperture through which the EUV light traveling toward the utilizing apparatus passes.

Debris deposited on the heat shield panel eventually becomes droplets when they reach a certain amount, and the droplets collect at a lower portion of the heat shield panel due to the gravitational force and fall into a debris container (tin recycling container).

### BACKGROUND DOCUMENT(S)

### PATENT DOCUMENT(S)

Patent Document 1: JP-A-2017-219698

### SUMMARY OF THE INVENTION

As the output power of EUV light sources increases, the heat emitted from the plasma also increases, and the debris trap may be damaged due to overheating. In addition to the direct heat radiation from the plasma through the aperture of the heat shield panel to the debris trap, the debris trap is also subjected to a secondary heat radiation emitted from the heat shield panel heated by the heat radiation from the plasma. Accordingly, to reduce the heat load on the debris trap, the temperature of the heat shield panel should be lowered.

However, if the heat shield panel is cooled excessively, the melting debris will solidify and accumulate on the heat shield panel. It is desirable that debris that reaches the heat shield panel should collect as liquid phase at a lower portion of the heat shield panel due to the gravitational force and should fall into the debris container. When debris is deposited as solid phase, the debris grows as if it were a stalagmite in a stalactite cave. When the deposited mass of debris grows, it may block the aperture of the heat shield panel or may interfere with other components, thereby preventing a stable operation of the light source apparatus. Accordingly, while the light source is emitting light, the temperature of the heat shield panel should be maintained above the melting point of tin (about 232°degrees Celsius), which is the majority of the debris.

Accordingly, it is an object of the present invention to provide an extreme ultraviolet light source device that prevents overheating of a debris trap and prevents a stable operation of the device from being interrupted by debris deposited on the heat shield panel.

In accordance with an aspect of the present invention, there is provided an extreme ultraviolet light source apparatus, including a light source part configured to generate a plasma that emits extreme ultraviolet light; a vacuum housing located between the light source part and a utilizing apparatus in which the extreme ultraviolet light is utilized; a debris trap located inside the vacuum housing and configured to deflect traveling directions of debris particles emitted from the plasma toward the utilizing apparatus from a ray direction of the extreme ultraviolet light; a heat shield panel structure located inside the vacuum housing and located between the plasma and the debris trap; and a cooling mechanism configured to cool the heat shield panel structure. The heat shield panel structure has a first heat shield panel and a second heat shield panel overlapping the first heat shield panel, the first heat shield panel and the second heat shield panel being disposed at an interval. The second heat shield panel is disposed between the first heat shield panel and the plasma. The first heat shield panel is configured to be cooled by the cooling mechanism.

In this aspect, even if the second heat shield panel that is closer to the plasma and the debris deposited thereon become hot due to heat radiation from the plasma, overheating of the debris trap behind the first heat shield panel can be prevented by making the first heat shield panel that is farther from the plasma cooler than the second heat shield panel.

Preferably, the cooling mechanism has cooling water pipe configured to cool the vacuum housing and a holding member that is brought into contact with the vacuum housing and that is configured to hold the first heat shield panel.

In this case, the heat of the first heat shield panel is conducted through the holding member to the vacuum housing that is cooled by the cooling water pipe, and therefore the first heat shield panel is cooled.

More preferably, the second heat shield panel is spaced apart from the vacuum housing and the cooling mechanism and is not directly connected to the first heat shield panel.

In this case, the second heat shield panel is not subject to direct heat conduction from the vacuum housing, the first heat shield panel, and the cooling mechanism, so that the second heat shield panel is maintained at a high temperature when it receives heat radiation from the plasma.

Preferably, the second heat shield panel has a central portion made of tungsten and a peripheral portion made of molybdenum and surrounding the central portion, and the central portion and the peripheral portion are replaceably connected.

In this case, the durability of the second heat shield panel is improved by forming the central portion, which is closer to the plasma and is likely to have a higher temperature, from tungsten having a higher melting point. The cost of the second heat shield panel can be reduced since the peripheral portion is formed from molybdenum, which is less expensive than tungsten. Since the peripheral portion is formed from molybdenum, which has higher flexibility, it is easy to bend the peripheral portion to conform to the arrangement of surrounding components. In addition, since the central portion and the peripheral portions are replaceably connected, if the central portion is damaged by a high temperature, only the central portion can be replaced and the peripheral portion can be reused.

### EFFECT OF THE INVENTION

In the aspect of the present invention, debris deposited on the heat shield panel can be maintained at a high temperature and overheating of the debris trap can be prevented.

### BRIEF DESCRIPTION OF THE DRAWINGS

FIG. 1 is a schematic view showing an extreme ultraviolet light source apparatus according to an embodiment of the present invention;
FIG. 2 is a side cross-sectional view showing a part of the extreme ultraviolet light source apparatus according to the embodiment;
FIG. 3 is a front view of a rotating foil trap in the extreme ultraviolet light source according to the embodiment;
FIG. 4 is a side cross-sectional view of a heat shield panel structure according to the embodiment;
FIG. 5 is a top cross-sectional view of the heat shield panel structure;
FIG. 6 is a perspective view of the heat shield panel structure according to the embodiment;
FIG. 7 is a perspective view of a first heat shield panel of the heat shield panel structure according to the embodiment; and
FIG. 8 is a perspective view of a second heat shield panel of the heat shield panel structure according to the embodiment.

### DESCRIPTION OF EMBODIMENT

Hereinafter, with reference to the accompanying drawings, an embodiment according to the present invention will be described. It is of note that the drawings are not necessarily to scale, and certain features may be exaggerated or omitted.

An extreme ultraviolet light source apparatus (EUV light source apparatus) 1 is an apparatus that is configured to emit extreme ultraviolet light (EUV light) having a wavelength of, for example, 13.5 nm, and that can be used as a light source apparatus of a lithography apparatus for manufacturing semiconductor devices or as a light source apparatus for an apparatus for inspecting masks used for lithography.

The EUV light source apparatus 1 according to the embodiment is an EUV light source apparatus of the LDP type. More specifically, the EUV light source apparatus uses an energy beam such as a laser beam to irradiate a plasma raw material in a liquid phase applied to the surfaces of the pair of electrodes to vaporize the plasma raw material, and an electric power source to supply electric power to the electrodes to cause a discharge and generate a high-temperature plasma between the electrodes. EUV light is emitted from the plasma.

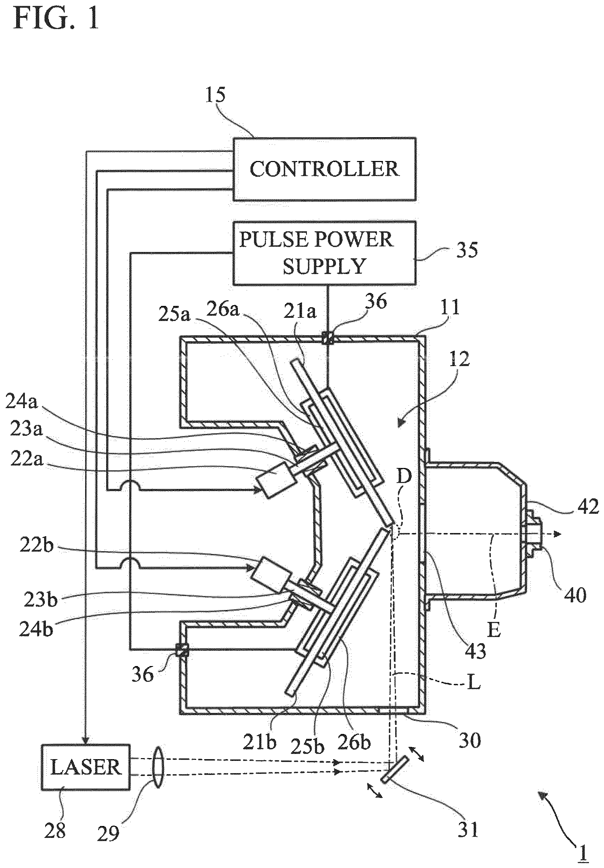

As shown in FIG. 1, the EUV light source apparatus 1 includes a chamber 11 in which the plasma is generated. The chamber 11 is formed of a rigid material, for example, a metal. The interior of the chamber (vacuum housing) 11 is evacuated to reduce attenuation of the EUV light.

The illustration of the interior of the chamber 11 in FIG. 1 is a plan view of the interior of the chamber 11.

A light source part 12 that emits extreme ultraviolet light is disposed inside the chamber 11. The light source part 12 has a pair of discharge electrodes 21a and 21b. The discharge electrodes 21a and 21b are each discs of the same shape and the same size; the discharge electrode 21a is used as a cathode, whereas the discharge electrode 21b is used as an anode. The discharge electrodes 21a and 21b are formed of, for example, a high-melting-point metal, such as tungsten, molybdenum, or tantalum.

The discharge electrodes 21a and 21b are disposed at positions spaced apart from each other, but the peripheral portions of the discharge electrodes 21a and 21b are close to each other. At a position in which the peripheral portion of the cathode 21a and the peripheral portion of the anode 21b are closest, a discharge occurs in the gap between the cathode 21a and the anode 21b, and a high-temperature plasma is generated. Hereinafter, the gap between the cathode 21a and the anode 21b at the position in which the peripheral portion of the cathode 21a and the peripheral portion of the anode 21b are closest is referred to as a "discharge region D".

The cathode 21a is connected to the rotational shaft 23a of the motor 22a and rotates about the axis of the cathode 21a. The anode 21b is connected to the rotational shaft 23b of the motor 22b and rotates about the axis of the anode 21b. The motors 22a and 22b are disposed outside the chamber 11, and the rotational shafts 23a and 23b extend from the outside the chamber 11 to the inside. The gap between the rotational shaft 23a and the wall of the chamber 11 is sealed with a sealing member, for example, a mechanical seal 24a, and the gap between the rotational shaft 23b and the wall of the chamber 11 is also sealed with a sealing member, for example, a mechanical seal 24b. The sealing members allow rotation of the rotational shafts 23a and 23b while maintaining a reduced-pressure atmosphere in the chamber 11.

Thus, the discharge electrodes 21a and 21b are respectively driven by separate motors 22a and 22b. The rotation of each of the motors 22a and 22b is controlled by the controller 15.

A container 26a for storing a liquid-phase plasma raw material 25a and a container 26b for storing a liquid-phase plasma raw material 25b are disposed inside the chamber 11. The heated liquid-phase plasma raw materials 25a and 25b are supplied to the containers 26a and 26b. The liquid-phase plasma raw materials 25a and 25b are, for example, tin (Sn).

A lower part of the cathode 21a is immersed in the plasma raw material 25a in the container 26a, and a lower part of the anode 21b is immersed in the plasma raw material 25b in the container 26b. As a result, the plasma raw material adheres to the discharge electrodes 21a and 21b. As the discharge electrodes 21a and 21b rotate, the liquid-phase plasma raw materials 25a and 25b are transported to the discharge region D at which a high-temperature plasma is to be generated.

There is placed outside the chamber 11 a laser (energy beam irradiation device) 28 that irradiates the plasma raw material 25a on the cathode 21a with an energy beam to vaporize the plasma raw material 25a. The laser 28 is, for example, Nd:YVO₄ laser (Neodymium-doped Yttrium Orthovanadate laser), and emits an infrared laser beam L. However, the energy beam irradiation device may be another device that emits a beam other than a laser beam capable of vaporizing the plasma raw material 25a.

Illumination timing of the laser beam by the laser 28 is controlled by the controller 15. The infrared laser beam L emitted from the laser 28 is directed to a movable mirror 31.

Between the laser 28 and the movable mirror 31, typically a light-collecting means is disposed. The light-collecting means includes, for example, a condensing lens 29.

The infrared laser beam L is reflected by the movable mirror 31 disposed outside the chamber 11, passes through a transparent window 30 provided on the wall of the chamber 11, and illuminates the outer peripheral surface of the cathode 21a in the vicinity of the discharge region D.

To facilitate irradiation on the outer peripheral surface of the cathode 21a with the infrared laser beam L, the axes of the discharge electrodes 21a and 21b are not parallel. The interval between the rotational shafts 23a and 23b is narrower on the motor side and is wider on the electrode side.

The anode 21b is located between the cathode 21a and the movable mirror 31. In other words, the infrared laser beam L reflected by the movable mirror 31 passes through the vicinity of the outer peripheral surface of the anode 21b, and then reaches the outer peripheral surface of the cathode 21a. The anode 21b is retracted behind the cathode 21a toward the left side of FIG. 1 so as not to interfere with the progress of the infrared laser beam L.

The liquid-phase plasma raw material 25a on the outer peripheral surface of the cathode 21a in the vicinity of the discharge region D is vaporized by irradiation with the infrared laser beam L, and a gas-phase plasma raw material is generated in the discharge region D.

To generate a high-temperature plasma in the discharge region D (to transform the plasma raw material in a gas phase to a plasma), a pulse power supply 35 supplies electric power to the cathode 21a and the anode 21b, to cause a discharge between the cathode 21a and the anode 21b. The pulse power supply 35 periodically supplies pulsed electric power to the discharge electrodes 21a and 21b.

The pulse power supply 35 is located outside the chamber 11. Electric supply lines extending from the pulse power supply 35 pass through sealing members 36, which are embedded in the wall of the chamber 11 to maintain a reduced-pressure atmosphere within the chamber 11, and extend into the interior of the chamber 11.

In this embodiment, the two electric supply lines extending from the pulse power supply 35 are connected to the containers 26a and 26b, respectively. The containers 26a and 26b are made of an electric conductive material, and the plasma raw materials 25a and 25b inside the containers 26a and 26b are an electric conductive material, i.e., tin. The discharge electrodes 21a and 21b are immersed in the plasma raw materials 25a and 25b inside the containers 26a and 26b. Thus, when the pulse power supply 35 supplies pulsed electric power to the containers 26a and 26b, the pulsed electric power is consequently supplied to the discharge electrodes 21a and 21b.

When discharge occurs between the cathode 21a and the anode 21b, the plasma raw material in a gas phase in the discharge region D is heated and excited by a large current, so that a high-temperature plasma is generated. In addition, due to the high heat generated, the liquid-phase plasma raw material 25b on the outer peripheral surface of the anode 21b in the vicinity of the discharge region D is also converted into plasma.

EUV light E is emitted from the high temperature plasma. EUV light E is used in a utilizing apparatus 40, which is another optical apparatus (a lithography apparatus or an inspection apparatus for masks). A connection chamber (vacuum housing) 42 is located between the chamber 11 and the utilizing apparatus 40. The interior space of the connection chamber 42 is connected to (communicates with) the chamber 11 through a window 43, which is a through-hole formed in the wall of the chamber 11. The connection chamber 42 is also connected to (communicates with) the utilizing apparatus 40. In the drawings, only a part of the utilizing apparatus 40 is shown. In addition, in FIG. 1, illustration of details of the connection chamber 42 are omitted.

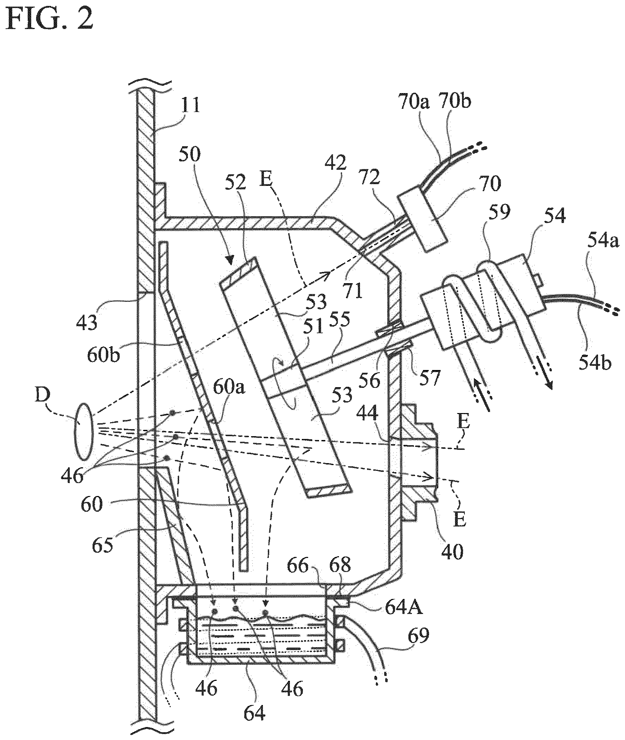

As shown in the side cross-sectional view in FIG. 2, the wall of the connection chamber 42 has a window 44, which is a through-hole, and the interior space of the connection chamber 42 is connected to (communicates with) the utilizing apparatus 40 through the window 44. The interior of the connection chamber 42 is also evacuated to reduce the attenuation of EUV light E. The EUV light E emitted from the plasma in the discharge region D is introduced into the utilizing apparatus 40 through the windows 43 and 44.

On the other hand, debris particles 46 are emitted from the plasma. The debris particles 46 include tin particles, which are the raw material for the high-temperature plasma, and material particles of the discharge electrodes 21a and 21b, which are results of slight chipping of the discharge electrodes due to the energy beam irradiation. When the debris particles 46 reach the utilizing apparatus, they may damage or contaminate reflective films of optical elements in the utilizing apparatus 40 and degrade the performance of the optical elements. Accordingly, a debris trap is provided in the connection chamber 42 to deflect the traveling directions of the debris particles 46 from the ray direction of the EUV light so that debris particles 46 do not ingress into the utilizing apparatus 40. In this embodiment, the debris trap has a rotating foil trap 50 that traps the debris particles 46 by means of a rotating motion. Although not shown, a stationary foil trap may be provided in the connection chamber 42.

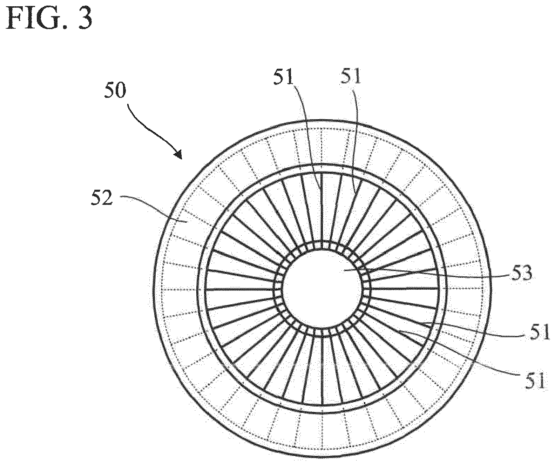

The rotating foil trap 50 has a configuration disclosed in Patent Document 1. Specifically, as shown in FIGS. 2 and 3, the rotating foil trap 50 has a central hub 51, an outer ring 52 that is concentric to the hub 51, and a large number of foils 53 disposed between the hub 51 and the outer ring 52. Each foil 53 is a thin film or a thin flat plate. The foils 53 are arranged radially with equal angular intervals. Each foil 53 lies in a plane containing the central axis of the hub 51. The material for the rotating foil trap 50 is a high-melting-point metal such as tungsten and/or molybdenum.

The hub 51 is connected to or coupled with the rotational shaft 55 of a motor (rotation drive device) 54, and the central axis of the hub 51 is aligned with the central axis of the rotational shaft 55. The rotation shaft 55 can be regarded as the rotational shaft of the rotating foil trap 50. Driven by the motor 54, the rotating foil trap 50 rotates, and the rotating foils 53 trap incoming debris particles 46 and prevent the debris particles 46 from entering the utilizing apparatus 40.

Whereas the rotating foil trap 50 is located inside the connection chamber 42, the motor 54 is located outside the connection chamber 42. A through-hole 56 is formed in the wall of the connection chamber 42, and the rotational shaft 55 passes through the through-hole 56. The gap between the rotational shaft 55 and the wall of the connection chamber 42 is sealed with a sealing member such as a mechanical seal 57.

Since the rotating foil trap 50 becomes hot due to heat radiation from the plasma, the rotating shaft 55 may be made hollow and cooled by circulating cooling water in order to prevent overheating. In addition, a cooling water pipe 59 is wrapped around the motor 54 to prevent burnout of the motor 54 itself. Water circulates through the cooling water pipe 59, and removes heat from the motor 54 through heat exchange.

In addition, to reduce heat radiation from the plasma to the rotating foil trap 50 and prevent overheating thereof, a heat shield panel structure 60 made of a high-melting-point metal is disposed within the connection chamber 42. The heat shield panel structure 60 is interposed between the plasma and the rotating foil trap 50. The heat shield panel structure 60 has an aperture 60a that penetrates the heat shield panel structure 60. The aperture 60a is located in a midpoint between the window 44 and the plasma.

The plasma emits EUV light E in various directions. Part of the EUV light E is introduced into the utilizing apparatus 40 through the window 43 of the chamber 11, the aperture 60a of the heat shield panel structure 60, the clearances between the multiple foils 53 of the rotating foil trap 50, and the window 44. The foils 53 of the rotating foil trap 50 are arranged parallel to the ray direction of the EUV light E traveling toward the window 44 so as not to block the EUV light E traveling from the plasma (light emission point) toward the window 44. In other words, for the rotating foil trap 50 in which each foil 53 is arranged on a plane including the central axis of the hub 51 as shown in FIG. 2, if the plasma (light emission point) is arranged on an extension of the central axis of the hub 51, the ratio (also called transmittance) of the EUV light that can pass through the rotating foil trap 50 without being shielded by each foil 53 can be maximized.

In this embodiment, the motor 54 for rotating the rotating foil trap 50 is located outside the connection chamber 42 within which the rotating foil trap 50 is located. Therefore, it is easy to inspect and repair the motor 54, wirings 54a and 54b of the motor 54, and the cooling water pipe 59. In addition, since the wirings 54a and 54b of the motor 54 and the cooling water pipe 59 are located outside the connection chamber 42, the sealing points in the connection chamber 42 can be fewer than those in a case in which they are located inside the connection chamber 42. The reliability of the apparatus can be improved by reducing the number of vacuum sealing points since the number of vacuum leakage inspection points during assembly and maintenance work can be reduced and the risk of vacuum leakage due to aging deterioration is reduced. Furthermore, since the motor 54 is located outside the connection chamber 42, the motor 54 can be cooled easily.

On the other hand, the debris particles 46 are also emitted from the plasma in various directions. Some of the debris particles 46 enter the connection chamber 42 through the window 43 of the chamber 11. A debris container 64 is located below the connection chamber 42, so that the debris particles 46 fall into the debris container 64. Some of the debris particles 46 that enter the connection chamber 42 are deposited on the heat shield panel structure 60. They are melted by the heat radiation applied to the heat shield panel structure 60 from the plasma, and when they reach a certain amount, they become droplets. The droplets gather in a lower portion of the heat shield panel structure 60 by the force of gravity and fall into the debris container 64. In this way, the heat shield panel structure 60 reduces the amount of the debris particles 46 traveling toward the rotating foil trap 50. Part of debris particles 46 that have entered the connection chamber 42 and tin that has leaked from the containers 26a and 26b are led to a receiving plate 65 that is heated by a heater and installed in the connection chamber 42, and fall into the debris container 64. Debris particles 46 that have entered the connection chamber 42 and have passed through the aperture 60a of the heat shield panel structure 60 are trapped by the foils 53 of the rotating foil trap 50, and then fall into the debris container 64.

The debris container 64 is located outside the connection chamber 42. A through-hole 66 is formed in the bottom wall of the connection chamber 42 to connect the interior space of the debris container 64 with the interior space of the connection chamber 42. The debris container 64 has a flange 64A at the top thereof. The opening of the debris container 64 surrounded by the flange 64A is aligned with the through-hole 66, and the flange 64A is fixed to the bottom wall of the connection chamber 42 with, for example, screws. The gap between the flange 64A and the bottom wall of the connection chamber 42 is sealed with a gasket 68 provided at the gap.

Since most of the debris particles 46 are tin, the debris container 64 may be called a tin recovery container. A heater wire 69 that heats the debris container 64 is wrapped around the debris container 64. During the period of use of the EUV light source apparatus 1, the interior of the debris container 64 is heated by the heater wire 69 at a temperature not less than the melting point of tin (about 232 degrees Celsius), and tin accumulated within the debris container 64 is turned into a liquid phase. The reason for turning tin inside the debris container 64 into liquid is that when solid debris particles 46 accumulate, the accumulated mass grows like stalagmites in a stalactite cave on one or more positions into which the debris particles 46 are likely to fall. If the debris accumulation grows into a stalagmite shape, it may be contact with the rotating foil trap 50, preventing the rotation of the rotating foil trap 50 or damaging the rotating foil trap 50. Alternatively, the accumulations may reach the optical path of the EUV light E traveling toward the window 44 and block the EUV light E. By turning tin inside the debris container 64 into a liquid phase, the top of accumulated tin inside the debris container 64 is flattened, allowing for efficient storage of tin.

When recovering tin accumulated in the debris container 64, heating by the heater wire 69 is stopped, and after the temperature of the debris container 64 returns to room temperature, the interior pressure of the connection chamber 42 is returned to the atmospheric pressure. Then, the debris container 64 is removed from the connection chamber 42, and a new debris container 64 without tin is mounted on the connection chamber 42.

Although tin inside the debris container 64 removed from the connection chamber 42 is in a solid phase, it can be taken out from the debris container 64 by reheating it.

In this embodiment, the debris particles 46, which are trapped by the rotating foil trap 50, fall into the debris container 64 through the through-hole 66 in the wall of the connection chamber 42. The debris container 64 is located outside the connection chamber 42. Therefore, the debris particles 46 do not adhere to the heater wire 69 that heats the debris container 64, and the heater wire 69 can be easily inspected and repaired. Furthermore, since the debris container 64 can be easily removed from the connection chamber 42, it is easy to replace the debris container 64 with a new debris container 64. After tin is removed from the debris container 64, the debris container 64 can be reused.

Furthermore, a monitoring device 70 for monitoring the EUV light E is located outside the connection chamber 42. The monitoring device 70 is a detector that detects the presence of EUV light E or a measuring device that measures the intensity of EUV light E.

An extreme-ultraviolet-light guiding hole 71 that is a through-hole allowing the EUV light E to pass is formed in the wall of the connection chamber 42, and a tube 72 through which the EUV light E pass without leaking is disposed between the extreme-ultraviolet-light guiding hole 71 and the monitoring device 70.

An aperture 60b is formed in and penetrates the above-mentioned heat shield panel structure 60, and the monitoring device 70, the extreme-ultraviolet-light guiding hole 71, and the tube 72 are aligned with an extension of a straight line connecting the plasma and the aperture 60b. Therefore, part of the EUV light E emitted from the plasma reaches the monitoring device 70 through the window 43 of the chamber 11, the aperture 60b of the heat shield panel structure 60, the clearances between the multiple foils 53 of the rotating foil trap 50, the extreme-ultraviolet-light guiding hole 71 in the wall of the connection chamber 42, and the lumen of the tube 72.

Thus, the EUV light E can be monitored by the monitoring device 70. Since the monitoring device 70 is located outside the connection chamber 42, it is easier to inspect and repair the monitoring device 70 and wirings 70a and 70b for the monitoring device 70 than in a case in which the monitoring device 70 is located inside the connection chamber 42. In addition, since the wiring 70a and 70b of the monitoring device 70 are located outside the connection chamber 42, the sealed points in the connection chamber 42 are fewer than those in a case in which they are located inside the connection chamber 42. Furthermore, since the monitoring device 70 is located outside the connection chamber 42, a cooling mechanism can be easily added if necessary, so that overheating of the monitoring device 70 can be prevented.

Next, the heat shield panel structure 60 will be described in detail.

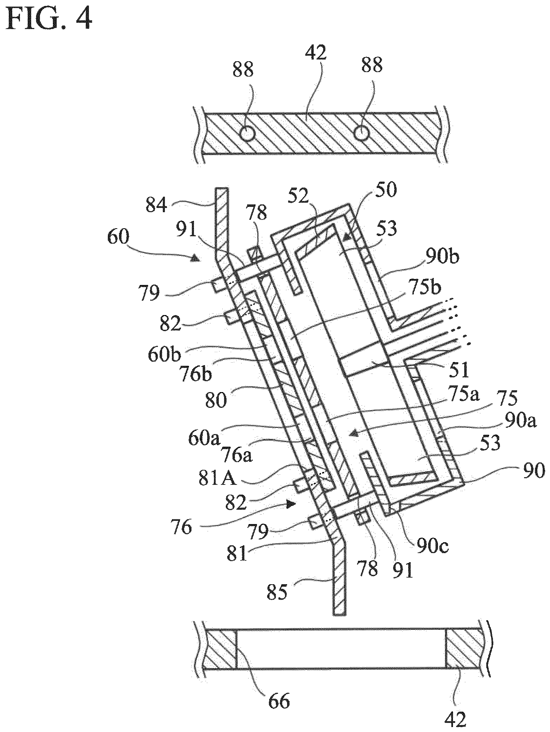

As shown in FIGS. 4 to 6, the heat shield panel structure 60 has a composite structure with two heat shield panels. Specifically, the heat shield panel structure 60 has a first heat shield panel 75 and a second heat shield panel 76. The second heat shield panel 76 is located between the first heat shield panel 75 and the plasma and is spaced apart and overlapped on the first heat shield panel 75.

The second heat shield panel 76 is replaceably connected by a plurality of screws 79 onto a plurality of posts 91 mounted on a support frame 90. The posts 91 pass through the through-holes 78 formed in the first heat shield panel 75. The support frame 90 supporting the second heat shield panel 76 is connected to the connection chamber 42 at a point that is not shown. As described below, the diameter of the through-holes 78 is greater than the diameter of the posts 91, and the first heat shield panel 75 and the posts 91 are arranged such that they do not contact each other.

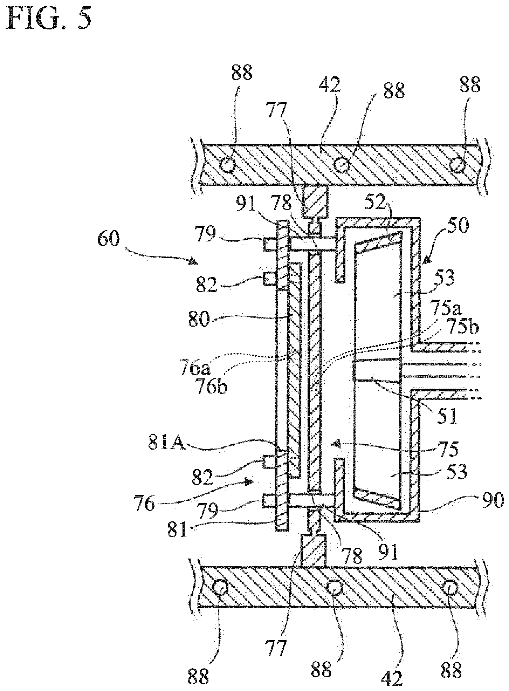

On the other hand, the first heat shield panel 75 is connected to the connection chamber 42 via a plurality of holding portions 77 (which will be described later with reference to Figs. 5 to 7). Thus, by mounting the second heat shield panel 76 on the support frame 90 through the posts 91 that pass through the through-holes 78 of the first heat shield panel 76 without directly attaching the second heat shield panel 76 to the first heat shield panel 75 and without contact of the first heat shield panel 75 with the first heat shield panel 76, heat conduction between the second heat shield panel 76 and the first heat shield panel 75 can be minimized. The support frame 90 and the posts 91 are made of a metallic material such as titanium or stainless steel, which has relatively low thermal conductivity, or a ceramic material such as alumina (Al₂O₃) or zirconia (ZrO₂).

A through-hole 75a in the first heat shield panel 75 and a through-hole 76a in a central portion 80 of the second heat shield panel 76 are positioned and form the aperture 60a described above. The aperture 60a allows the EUV light E to travel from the plasma to the utilizing apparatus 40.

Similarly, a through-hole 75b in the first heat shield panel 75 and a through-hole 76b in the central portion 80 of the second heat shield panel 76 are also positioned and form the aperture 60b described above. The aperture 60b allows the EUV light E to travel from the plasma to the monitoring device 70.

Among the debris particles that are emitted from the plasma (light emission point) as the starting point, the debris particles that reach a plane containing the first heat shield panel 75 are limited by the through-holes 76a and 76b on the second heat shield panel 76. Preferably, the through-holes 75a and 75b should be sized and shaped to completely encompass the areas of the first heat shield panel 75 to which the debris particles can arrive. In other words, the size and shape of the through-holes 75a and 75b should be selected so that when a person tries to observe the first heat shield panel 75 from the plasma (light emission point) through the through-holes 76a and 76b in the second heat shield panel 76, the first heat shield panel 75 is in the shadow of the second heat shield panel 76 and is not visible. This is because the debris particles 46 travel straight from the plasma along with the EUV light E, but if the first heat shield panel 75 is exposed in an area that is not in the shadow of the second heat shield panel 76, the debris particles will be deposited directly on the first heat shield panel 75. For example, if the through-holes 75a and 76a are concentric, of the same diameter, and located on an optical axis and the through-holes 75b and 76b are concentric, of the same diameter, and located on an optical axis, the debris particles will be deposited around the through-holes 75a and 75b since they are not in the shadow of the second heat shield panel 76. In this case, since the first heat shield panel 75 is cooled as described below, the debris particles 46 continue to accumulate without melting. Eventually, the first heat shield panel 75 and the second heat shield panel 76 are connected by the deposited debris and heat conduction occurs therebetween, so that the temperature of the second heat shield panel 76 will be decreased and debris will also be deposited on the second heat shield panel 76.

The support frame 90 not only supports the second heat shield panel 76, but also functions to prevent scatter of the debris particles within the connection chamber 42 after the debris particles 46 are trapped by the rotating foil trap 50, move radially on the foils of the rotating foil trap 50 due to centrifugal force, and are separated from the edges of the foils. Accordingly, the entire circumference of the rotating foil trap 50 is covered with the support frame 90. The front wall of the support frame 90 (the wall on the side of the heat shield panel structure 60) is provided with an opening, and the rear wall of the support frame 90 (the wall opposite the heat shield panel structure 60) is provided with through-holes 90a and 90b. The through-hole 90a is located between the aperture 60a and the window 44 and allows the EUV light E to travel to the utilizing apparatus 40. The through-hole 90b is located between the aperture 60b and the extreme-ultraviolet-light guiding hole 71 and allows the EUV light E to travel to the monitoring device 70. A debris discharge hole 90c is formed at the lower end of the support frame 90. Debris separated from the rotating foil trap 50 falls through the discharge hole 90c and is received in the debris container 64 through the through-hole 66.

The first heat shield panel 75 is configured to be cooled by a cooling mechanism. In this embodiment, the cooling mechanism has a cooling water pipe 88 (see FIGS. 4 and 5) that cools the connection chamber 42 and holding portions 77 (which will be described later with reference to Figs. 5 to 7) that are connected to the connection chamber 42 and hold the first heat shield panel 75. The cooling water pipe 88 is located within the walls of the connection chamber 42 in the embodiment, but may be located outside or inside the connection chamber 42 and may be in contact with the walls of the connection chamber 42. In either case, heat from the first heat shield panel 75 is conducted through the holding portions 77 to the connection chamber 42, which is cooled by the cooling water pipe 88. Thus, the first heat shield panel 75 is cooled.

On the other hand, the second heat shield panel 76 is separated from the connection chamber 42 and the cooling mechanism (the cooling water pipe 88 and the holding portions 77) and is spaced apart from the first heat shield panel 75. Furthermore, the second heat shield panel 76 is not connected to the first heat shield panel 75 and is fixed to the posts 91 mounted on the support frame 90. Therefore, since there is no direct heat conduction between the first heat shield panel 75 and the second heat shield panel 76, the second heat shield panel 76 is maintained at a high temperature.

By not cooling the second heat shield panel 76, which is closer to the plasma, and by cooling the first heat shield panel 75, which is farther from the plasma, the first heat shield panel 75 have a lower temperature than that of the second heat shield panel 76, and therefore the secondary thermal radiation from the second heat shield panel 76, which has been heated by the plasma, is shielded by the first heat shield panel 75, and the debris trap behind the first heat shield panel 75 (in this embodiment, the rotating foil trap 50) can be prevented from overheating. In this case, the second heat shield panel 76 is not cooled by heat conduction and is maintained at a high temperature by radiation from the plasma. Therefore, the debris deposited on the second heat shield panel 76 eventually becomes droplets when it reaches a certain amount. The droplets then gather in a lower portion of the heat shield panel structure 60 by the force of gravity and fall into the debris container 64. Since the debris container 64 is heated at a temperature not less than the melting point of tin (about 232 degrees Celsius) by the heater wire, the accumulated debris, which is mainly tin, is flattened and stored as a liquid without being locally deposited.

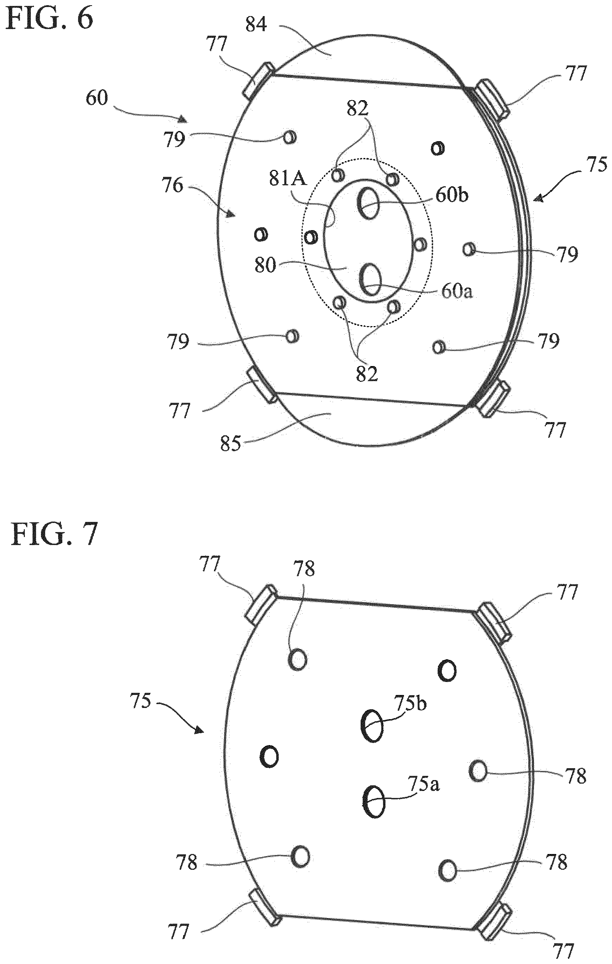

As shown in FIG. 7, the first heat shield panel 75 is a plate of which the thickness is several millimeters and has a shape of a disc with the top and bottom edges removed. The material of the first heat shield panel 75 is molybdenum. The melting point of molybdenum is about 2600 degrees Celsius, so that the first heat shield panel 75 has high heat resistance. Two through-holes 75a and 75b are formed in the center of the first heat shield panel 75, each having a shape that does not obstruct the light path of EUV light E from the plasma (light emission point) to the monitoring device 70 and the utilizing apparatus 40.

At the four corners of the first heat shield panel 75, holding portions 77 are formed to connect the first heat shield panel 75 with the connection chamber 42 and to hold the first heat shield panel 75. Thus, in this embodiment, the holding portions 77 for holding the first heat shield panel 75 is formed integrally with the first heat shield panel 75. However, the holding portions 77 are only necessary to have good heat conduction with the first heat shield panel 75, and may be separate members from the first heat shield panel 75. In a case in which the holding portions 77 are separate members from the first heat shield panel 75, they may be mounted on the first heat shield panel 75 by welding, brazing, screwing, etc. In such cases, the holding portions 77 may be made of a metal with good thermal conductivity such as tungsten, molybdenum, aluminum, or copper, or a ceramic material with good thermal conductivity such as silicon carbide (SiC), aluminum nitride (AIN), or boron nitride (BN).

A plurality of circular through-holes 78 are formed in the first heat shield panel 75. The diameter of each through-hole 78 is greater than the outer diameter of the cylindrical posts 91 for holding the second heat shield panel 76 on the support frame 90 behind it, so that the posts 91 are not in contact with the inner surfaces of the through-holes 78. The shape of the through-hole 78 does not necessarily have to be circular, and similarly, the shape of the posts 91 does not have to be cylindrical.

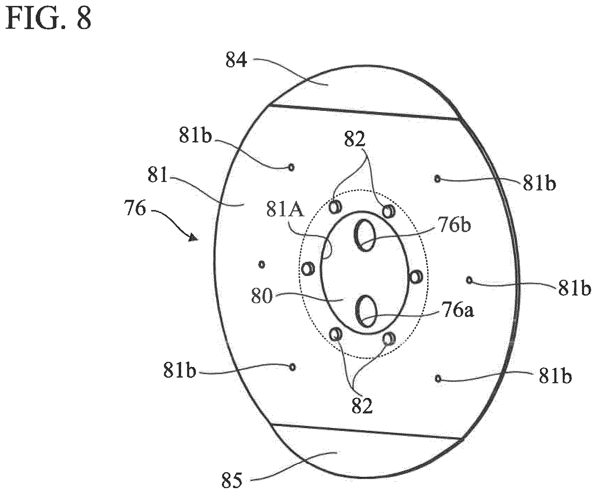

As shown in FIG. 8, the second heat shield panel 76 has a central portion 80 and a peripheral portion 81 surrounding the central portion 80. The central portion 80 and the peripheral portion 81 are replaceably connected by a plurality of screws 82. The central portion 80 is a disk made of tungsten having a thickness of several millimeters. The peripheral portion 81 is a disk made of molybdenum having a thickness of several millimeters, and has an outer diameter that is much greater than that of the central portion 80.

An aperture 81A is formed in and penetrates the center of the peripheral portion 81. The outer diameter of the central portion 80 is greater than the outer diameter of the aperture 81A, and the central portion 80 covers the aperture 81A. Two through-holes 76A and 76B are formed in the central portion 80.

A plurality of through-holes 81b are formed in the peripheral portion 81 of the second heat shield panel 76. The positions of the through-holes 81b correspond to the positions of the through-holes 78 of the first heat shield panel 75 and the posts 91 attached to the support frame 90. Screws 79 pass through the through-holes 81b and are fastened to screw holes in the posts 91.

The durability of the second heat shield panel 76 is improved by forming the central portion 80 in the second heat shield panel 76, which has a shorter linear distance from the plasma than the peripheral portion 81 and is likely to be hotter than the peripheral portion 81, from tungsten having a higher melting point. The cost for the second heat shield panel 76 can be reduced since the peripheral portion 81 is formed from molybdenum, which is less expensive than tungsten. Since the peripheral portion 81 is formed from molybdenum, which is highly flexible, it is easy to bend the peripheral portion 81 to conform to the arrangement of surrounding components. For example, in this embodiment, the top portion 84 and the lowest portion 85 of the peripheral portion 81 are bent so that the heat shield panel structure 60 can be arranged without interfering with the shape of the interior of the connection chamber 42. In addition, since the central portion 80 and the peripheral portion 81 are replaceably connected, if the central portion 80 is damaged by a high temperature, only the central portion 80 can be replaced and the peripheral portion 81 can be reused, thereby reducing the cost.

The present invention has been shown and described with reference to preferred embodiments thereof. However, it will be understood by those skilled in the art that various changes in form and detail may be made without departing from the scope of the invention as defined by the claims. Such variations, alterations, and modifications are intended to be encompassed in the scope of the present invention.

For example, in the above embodiment, the cooling mechanism for the heat shield panel structure 60 includes the cooling water pipe 88 that cools the connection chamber 42 and the holding portions 77 that hold the first heat shield panel 75. However, the heat shield panel structure 60 may also be a cooling water pipe or a cooling air pipe (not shown) that is in contact with the first heat shield panel 75 to cool the first heat shield panel 75.

In the above embodiment, the second heat shield panel 76 consists of two portions: the central portion 80 and the peripheral portion 81. However, the entirety of the second heat shield panel 76 may be composed of a single member made of tungsten.

In the above embodiment, the heat shield panel structure 60 has two heat shield panels 75 and 76. However, the heat shield panel structure 60 may have more heat shield panels.

### REFERENCE SYMBOLS

1: Extreme ultraviolet light source device (EUV light source device)
12: Light source part
40: Utilizing apparatus
42: Connection chamber (vacuum housing)
46: Debris particle
50: Rotating foil trap (debris trap)
60: Heat shield panel structure
60a: Aperture
60b: Aperture
64: Debris container
70: Monitoring device
75: First heat shield panel
76: Second heat shield panel
77: Holding portion (cooling mechanism)
80: Central portion
81: Peripheral portion
88: Cooling water pipe (cooling mechanism)

## Claims

1. An extreme ultraviolet light source apparatus, comprising:
a light source part configured to generate a plasma that emits extreme ultraviolet light;
a vacuum housing located between the light source part and a utilizing apparatus in which the extreme ultraviolet light is utilized;
a debris trap located inside the vacuum housing and configured to deflect traveling directions of debris particles emitted from the plasma toward the utilizing apparatus from a ray direction of the extreme ultraviolet light;
a heat shield panel structure located inside the vacuum housing and located between the plasma and the debris trap; and
a cooling mechanism configured to cool the heat shield panel structure,
the heat shield panel structure having a first heat shield panel and a second heat shield panel overlapping the first heat shield panel, the first heat shield panel and the second heat shield panel being disposed at an interval,
the second heat shield panel being disposed between the first heat shield panel and the plasma,
the first heat shield panel being configured to be cooled by the cooling mechanism.

2. The extreme ultraviolet light source apparatus according to claim 1, wherein the cooling mechanism has a cooling water pipe configured to cool the vacuum housing and a holding member that is brought into contact with the vacuum housing and that is configured to hold the first heat shield panel.

3. The extreme ultraviolet light source apparatus according to claim 2, wherein the second heat shield panel is spaced apart from the vacuum housing and the cooling mechanism and is not connected to the first heat shield panel.

4. The extreme ultraviolet light source apparatus according to any one of claims 1 to 3, wherein the second heat shield panel has a central portion made of tungsten and a peripheral portion made of molybdenum and surrounding the central portion, and the central portion and the peripheral portion are replaceably connected.
